# EUROPEAN PATENT SPECIFICATION

(11) **EP 4 270 710 B1**
(45) Date of publication and mention of the grant of the patent: **11.02.2026**
(21) Application number: 23168566.0
(22) Date of filing: 18.04.2023
(51) Int. Cl.: H02J 3/00, H02J 3/38, G01R 27/02, G01R 31/42

(54) **INSULATION MONITORING ON BOTH SIDES OF AN INVERTER SUPPLIED BY RENEWABLE ENERGY**
ÜBERWACHUNG DES ISOLATIONSZUSTANDS AUF BEIDEN SEITEN EINES MIT ERNEUERBARER ENERGIE GESPEISTEN INVERTERS
SURVEILLANCE D'ISOLATION DES DEUX CÔTÉS D'UN ONDULEUR ALIMENTÉ PAR UNE ÉNERGIE RENOUVELABLE

(30) Priority: 20.04.2022 CN 202210416082
(43) Date of publication of application: 01.11.2023
(73) Proprietor: Sungrow Power Supply Co., Ltd., Hefei, Anhui 230088 (CN)
(72) Inventor: TIAN, Zisi, Hefei, 230088 (CN); LIANG, Cheng, Hefei, 230088 (CN); YAO, Pei, Hefei, 230088 (CN); LI, Xia, Hefei, 230088 (CN); DING, Jie, Hefei, 230088 (CN); ZHANG, Jin, Hefei, 230088 (CN)
(74) Representative: Rooney, John-Paul

(56) References cited:
- EP-A1- 4 080 758
- WO-A1-2022/032635
- CN-U- 209 982 435

## Description

### FIELD

The present disclosure relates to the technical field of solar photovoltaic power generation, and in particular to a method and an apparatus for insulation monitoring as well as a system for generating electricity from renewable energy.

### BACKGROUND

In a process of generating electricity from solar energy, an inverter converts the solar energy into a sinusoidal current, which has the same frequency and phase as a power grid, to be fed into the power grid. During this process, photovoltaic panels are exposed to potential induced degradation (PID) due to their characteristics, resulting in unrelenting degradation of performance of the photovoltaic panels. Eventually, the photovoltaic panels fail to operate normally for generating electricity. Therefore, it is necessary to prevent the PID.

According to the conventional technology, an anti-PID device commonly raises a voltage of a negative pole of a photovoltaic string relative to ground, in order to prevent the PID from occurring in the photovoltaic panels. However, an insulation monitoring device (IMD) arranged at an alternating-current side fails to monitor ground insulation throughout the operation of the anti-PID device because that the anti-PID device includes a ground loop. In view of this, the insulation monitoring device normally operates only at night according to the conventional technology, failing to meet the requirements of IEC standards that the insulation monitoring device should perform insulation monitoring around the clock.

Therefore, it is absolutely imperative by those skilled in the art to perform insulation monitoring around the clock while preventing the PID.

WO 2022/032635 A1 discloses a linkage protection system and method for a photovoltaic power station. The system comprises an inverter, an anti-potential induced degradation (PID) module, and an insulation monitoring module. The anti-PID module is used for injecting voltage to an input end or an output end of the inverter to raise or lower voltage of a photovoltaic system to earth. The insulation monitoring module is used for injecting voltage for insulation monitoring to a DC side or an AC side of the inverter. The anti-PID module and the insulation monitoring module are in direct or indirect communication with each other to obtain information about whether the other party is working and to perform linkage control, to realize that the anti-PID module and the insulation monitoring module work alternately in time periods. Because the anti-PID module and the insulation monitoring module would not work simultaneously, the problem that the voltage injected when the anti-PID module is working is detected by the insulation monitoring module, causing the insulation monitoring module to issue an abnormal insulation alarm can be avoided. Moreover, the system can realize anti-PID function, and can also perform insulation failure detection, improving power generating efficiency of the photovoltaic power station and ensuring the safety thereof.

CN 209 982 435 U discloses an anti-PID device of a photovoltaic system and the photovoltaic system. The anti-PID device comprises an adjustable voltage source, an equivalent neutral point circuit, a switch array and a controller. Wherein the adjustable voltage source is connected with the equivalent neutral point circuit through the switch array, and the equivalent neutral point circuit is used for constructing an alternating current side equivalent neutral point equivalent to a direct current side neutral point in the photovoltaic system. According to the PID-preventing device, the switching state in the switch array and the output voltage of the adjustable voltage source are controlled by the controller to adjust the voltage to ground of the equivalent neutral point on the alternating current side, so that the voltage to ground of the positive electrode or the negative electrode of the inverter is adjusted, and the PID effect of the photovoltaic module is inhibited. That is to say, the PID prevention device can adjust the voltage to ground of the positive electrode of the inverter and also can adjust the voltage to ground of the negative electrode of the inverter.

### SUMMARY

The invention provides a method for insulation monitoring according to claim 1, an apparatus for insulation monitoring according to claim 14, and a system for generating electricity from renewable energy according to claim 15. Preferred embodiments are defined in the dependent claims.

In view of this, a method and an apparatus for insulation monitoring, as well as a system for generating electricity from renewable energy are provided, so as to perform insulation monitoring around the clock while preventing the PID.

A method for insulation monitoring is provided according to the present disclosure. The method includes: controlling an alternating-current insulation monitoring device to constantly perform alternating-current insulation monitoring at an alternating-current side of an inverter when it is monitored that the inverter is shut down; performing direct-current insulation monitoring at a direct-current side of the inverter before the inverter is connected to a power grid when it is monitored that alternating-current insulation resistance meets a preset normal alternating-current resistance condition and that the inverter operates and meets a grid-connected condition; and controlling the inverter to be connected to the power grid and stopping the alternating-current insulation monitoring and the direct-current insulation monitoring when it is monitored that direct-current insulation resistance meets a preset normal direct-current resistance condition, and controlling an anti-PID device and the alternating-current insulation monitoring device to alternately operate in a period during which the inverter is connected to the power grid.

In an embodiment, the method further includes: determining that an alternating-current insulation fault occurs at the alternating-current side, outputting a first alternating-current insulation fault prompt message and disconnecting a low-voltage system where the inverter is located from the power grid when it is monitored that a period during which the alternating-current insulation resistance is less than a first fault threshold reaches a first preset period of time, in a case that the inverter is shut down.

In an embodiment, the method further includes: determining that the alternating-current insulation resistance is abnormal and outputting a first alarm message indicating that the alternating-current insulation resistance is abnormal when it is monitored that a period during which the alternating-current insulation resistance is greater than the first fault threshold and less than a first alarm threshold reaches a second preset period of time, in a case that the inverter is shut down.

In an embodiment, the method further includes: determining that the alternating-current insulation resistance returns to normal, stopping outputting the first alarm message and stopping the alternating-current insulation monitoring once it is monitored that the alternating-current insulation resistance is greater than a first recovery threshold and less than the first alarm threshold, in a case that the inverter is shut down.

In an embodiment, the method further includes: determining that an insulation fault occurs when it is monitored that a period during which the alternating-current insulation resistance is less than a second fault threshold reaches a second preset period of time and determining based on a predetermined fault location solution whether the insulation fault occurs at the alternating-current side or a direct-current side, in the period during which the inverter is connected to the power grid.

In an embodiment, the determining based on a predetermined fault location solution whether the insulation fault occurs at the alternating-current side or the direct-current side includes: controlling the inverter to be shut down and triggering the direct-current insulation monitoring, and determining that the insulation fault occurs at the direct-current side in a case that insulation resistance of a positive pole of a photovoltaic string to ground or insulation resistance of a negative pole of the photovoltaic string to ground is less than a protection threshold; and triggering the alternating-current insulation monitoring, and determining that the insulation fault occurs at the alternating-current side when it is monitored that the alternating-current insulation resistance is less than a third fault threshold.

In an embodiment, the method further includes: outputting a second alternating-current insulation fault prompt message and disconnecting a low-voltage system where the inverter is located from the power grid when it is determined that the insulation fault occurs at the alternating-current side.

In an embodiment, the method further includes: controlling the inverter to stop operating and constantly performing insulation monitoring in response to failure in the disconnecting the low-voltage system from the power grid; and stopping outputting the second alternating-current insulation fault prompt message and controlling the inverter to resume operating so as to be connected to the power grid when the insulation fault is successfully removed.

In an embodiment, the method further includes: determining that the alternating-current insulation resistance is abnormal and outputting a second alarm message indicating that the alternating-current insulation resistance is abnormal when it is monitored that a period during which the alternating-current insulation resistance is greater than the second fault threshold and less than a second alarm threshold reaches a third preset period of time, in the period during which the inverter is connected to the power grid.

In an embodiment, the method further includes: determining that the alternating-current insulation resistance returns to normal, stopping outputting the second alarm message and stopping performing the alternating-current insulation monitoring once it is monitored that the alternating-current insulation resistance is greater than the second alarm threshold, in the period during which the inverter is connected to the power grid.

In an embodiment, the method further includes: in the period during which the inverter is connected to the power grid, resetting a timer for the insulation monitoring and constantly performing the alternating-current insulation monitoring forcefully when it is monitored that an alarm indicator indicating low insulation resistance is valid; and determining that the alternating-current insulation resistance returns to normal, changing the alarm indicator indicating low insulation resistance to be invalid and stopping performing the alternating-current insulation monitoring when it is monitored that a period during which the alternating-current insulation resistance is greater than a second recovery threshold reaches a preset alternating-current insulation alarm recovery time period.

In an embodiment, the method further includes: switching, when the inverter stops or a fault other than an insulation fault occurs in the inverter in the period during which the inverter is connected to the grid, the insulation monitoring from a mode that the inverter is connected to the power grid to a mode that the inverter is shut down, in the period during which the inverter is connected to the grid.

In an embodiment, the controlling the alternating-current insulation monitoring device to constantly perform alternating-current insulation monitoring at an alternating-current side when it is monitored that an inverter is shut down includes: controlling the alternating-current insulation monitoring device to constantly perform the alternating-current insulation monitoring at the alternating-current side and controlling the anti-PID device to stop operating when it is monitored that the inverter is shut down in a case that the anti-PID device is arranged at the alternating-current side; or controlling the alternating-current insulation monitoring device to constantly perform the alternating-current insulation monitoring at the alternating-current side and controlling the anti-PID device to operate at the direct-current side of the inverter when it is monitored that the inverter is shut down in a case that the anti-PID device is arranged at the direct-current side.

An apparatus for insulation monitoring is provided according to the present disclosure. The apparatus includes an alternating-current insulation monitoring unit, a direct-current insulation monitoring unit and a control unit. The alternating-current insulation monitoring unit is configured to control an alternating-current insulation monitoring device to constantly perform alternating-current insulation monitoring at an alternating-current side of an inverter when it is monitored that the inverter is shut down. The direct-current insulation monitoring unit is configured to perform direct-current insulation monitoring at a direct-current side of the inverter before the inverter is connected to a power grid when it is monitored that alternating-current insulation resistance meets a preset normal alternating-current resistance condition and that the inverter operates and meets a grid-connected condition. The control unit is configured to control the inverter to be connected to the power grid and stop the alternating-current insulation monitoring and the direct-current insulation monitoring when it is monitored that direct-current insulation resistance meets a preset normal direct-current resistance condition, and control an anti-PID device and the alternating-current insulation monitoring device to alternately operate in a period during which the inverter is connected to the power grid.

A system for generating electricity from renewable energy is provided according to the present disclosure. The system for generating electricity from renewable energy includes an anti-PID device, an alternating-current insulation monitoring device and a control device. The control device includes a processor, a memory and a computer program stored in the memory and executable by the processor. The processor is configured to execute the computer program to perform the method for insulation monitoring.

The method and the device for insulation monitoring as well as the system for generating electricity from renewable energy are provided from the above technical solutions according to the present disclosure. When it is monitored that the inverter is shut down, the alternating-current insulation monitoring device is controlled to constantly perform alternating-current insulation monitoring at the alternating-current side. When it is monitored that alternating-current insulation resistance meets the preset normal alternating-current resistance condition and when the inverter operates and meets the grid-connected condition, the direct-current insulation monitoring is performed before the inverter is connected to the power grid. When it is monitored that direct-current insulation resistance meets the preset normal direct-current resistance condition, the inverter is controlled to be connected to the power grid, and the alternating-current insulation monitoring and the direct-current insulation monitoring are stopped. Further, the anti-PID device and the alternating-current insulation monitoring device are controlled to alternately operate in the period during which the inverter is connected to the power grid. Normally, the inverter is shut down throughout the nighttime and is connected to the power grid throughout the daytime. In view of this, the anti-PID device and the insulation monitoring device alternately operate depending on whether the inverter is shut down or connected to the power grid according to the present disclosure. In the period during which the inverter is shut down, the alternating-current insulation monitoring device constantly performs the alternating-current insulation monitoring. In the period during which the inverter is connected to the power grid, the anti-PID device and the alternating-current insulation monitoring device alternately operate with the anti-PID device operates first, so that the anti-PID can be compatible with the alternating-current insulation monitoring. Therefore, the insulation monitoring can be performed around the clock while preventing the PID according to the present disclosure, thereby solving the problem that the insulation monitoring device fails to operate around the clock currently.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. It is apparent that the drawings in the following description show only some embodiments of the present disclosure, and other drawings may be obtained by those skilled in the art from the drawings without any creative work.
Figure 1 is a flow chart illustrating a method for insulation monitoring according to an embodiment of the present disclosure;
Figure 2 is a schematic diagram illustrating a low-voltage system where an inverter is located in a case that an anti-PID device is arranged at a direct-current side according to an embodiment of the present disclosure;
Figure 3 is a schematic diagram illustrating a low-voltage system where an inverter is located in a case that an anti-PID device is arranged at an alternating-current side according to an embodiment of the present disclosure;
Figure 4 is a schematic diagram illustrating an example that an anti-PID device and an insulation monitoring device alternately operate around the clock according to an embodiment of the present disclosure;
Figure 5 is a flow chart illustrating the method for insulation monitoring performed in a period during which the inverter is shut down according to an embodiment of the present disclosure;
Figure 6 is a flow chart illustrating the method for insulation monitoring performed in a period during which the inverter is connected to a power grid according to an embodiment of the present disclosure;
Figure 7 is a schematic structural diagram illustrating an apparatus for insulation monitoring according to an embodiment of the present disclosure; and
Figure 8 is a schematic structural diagram illustrating a control device in a system for generating electricity from renewable energy according to an embodiment of the present disclosure.

### DETAILED DESCRIPTION OF EMBODIMENTS

Technical solutions of embodiments of the present disclosure are clearly and completely described hereinafter in conjunction with the drawings of the embodiments of the present disclosure. Apparently, in the following only some rather than all embodiments of the present disclosure are described.

A method and an apparatus for insulation monitoring, as well as a system for generating electricity from renewable energy are provided according to the embodiments of the present disclosure. When it is monitored that the inverter is shut down, the alternating-current insulation monitoring device is controlled to constantly perform alternating-current insulation monitoring at the alternating-current side. When it is monitored that alternating-current insulation resistance meets the preset normal alternating-current resistance condition and when the inverter operates and meets the grid-connected condition, the direct-current insulation monitoring is performed before the inverter is connected to the power grid. When it is monitored that direct-current insulation resistance meets the preset normal direct-current resistance condition, the inverter is controlled to be connected to the power grid, and the alternating-current insulation monitoring and the direct-current insulation monitoring are stopped. Further, the anti-PID device and the alternating-current insulation monitoring device are controlled to alternately operate in the period during which the inverter is connected to the power grid. Normally, the inverter is shut down throughout the nighttime and is connected to the power grid throughout the daytime. In view of this, the anti-PID device and the insulation monitoring device alternately operate depending on whether the inverter is shut down or connected to the power grid according to the present disclosure. In the period during which the inverter is shut down, the alternating-current insulation monitoring device constantly performs the alternating-current insulation monitoring. In the period during which the inverter is connected to the power grid, the anti-PID device and the alternating-current insulation monitoring device alternately operate with the anti-PID device operates first, so that the anti-PID can be compatible with the alternating-current insulation monitoring. Therefore, the insulation monitoring can be performed around the clock while preventing the PID according to the present disclosure, thereby solving the problem that the insulation monitoring device fails to operate around the clock currently.

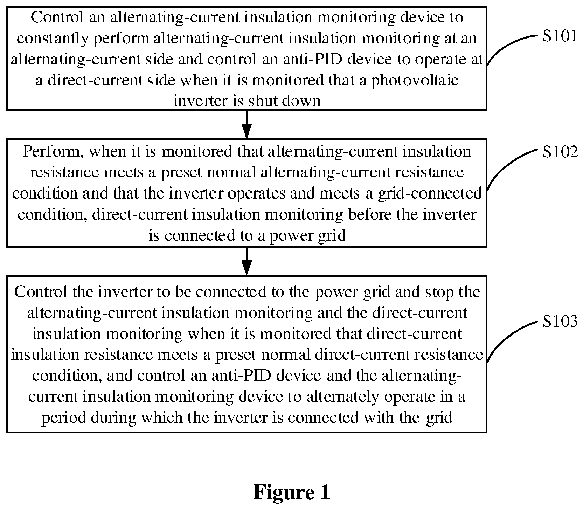

Reference is made to Figure 1, which is a flow chart illustrating a method for insulation monitoring according to an embodiment of the present disclosure. The method is applied to a control device in a system for generating electricity from renewable energy, and includes the following steps S101 to S103.

In step S101, an alternating-current insulation monitoring device at an alternating-current side is controlled to constantly perform alternating-current insulation monitoring when it is monitored that an inverter is shut down.

In practice, the inverter is shut down when an alternating-current switch inside the inverter is switched off, and alternating-current ground isolation is decoupled from direct-current ground isolation. The alternating-current insulation monitoring device constantly performs the alternating-current insulation monitoring at the alternating-current side.

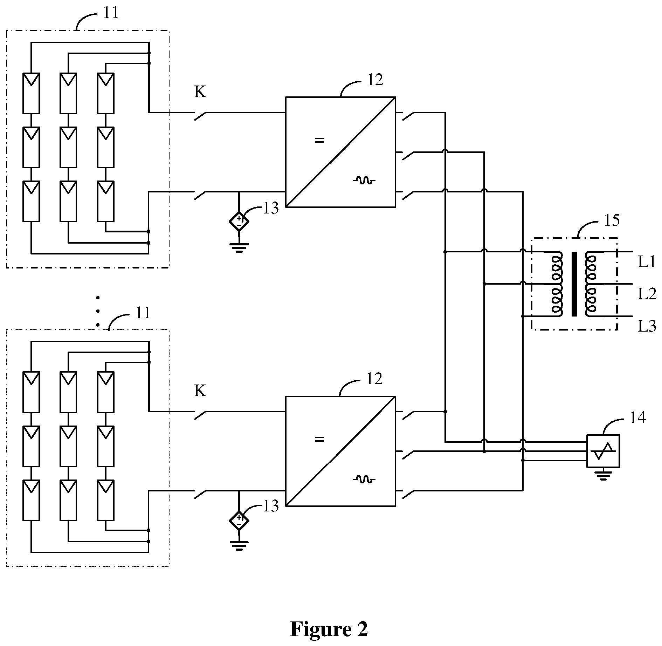

In a case the anti-PID device is arranged at a direct-current side (as shown in Figure 2 for details), the alternating-current insulation monitoring device is controlled to constantly perform alternating-current insulation monitoring at the alternating-current side and the anti-PID device is controlled (according to the original settings) to operate at the direct-current side when it is monitored that the inverter is shut down. In such case, the direct-current side is independent of the alternating-current side.

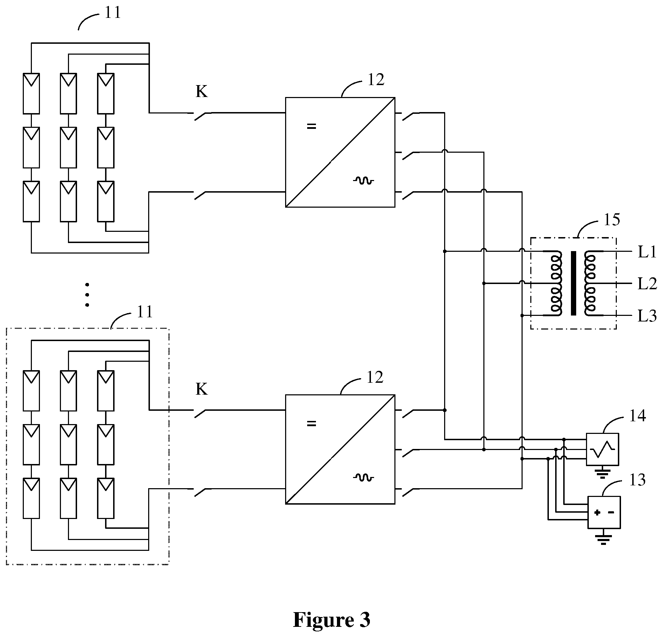

In another case the anti-PID device is arranged at the alternating-current side (as shown in Figure 3 for details), the alternating-current insulation monitoring device is controlled to constantly perform alternating-current insulation monitoring at the alternating-current side when it is monitored that the inverter is shut down.

Reference is made to Figure 2 in order to illustrate respective positions at which the alternating-current insulation monitoring device and the anti-PID device are arranged. A low-voltage system where an inverter is located includes a photovoltaic panel 11, an inverter 12, an anti-PID device 13, an alternating-current insulation monitoring device 14 and a transformer 15.

The photovoltaic panel 11 is connected to the inverter 12 through a switch K. One end of the anti-PID device 13 is connected to a direct-current side of the inverter 12, and the other end of the anti-PID device 13 is grounded.

The alternating-current insulation monitoring device 14 is connected to an alternating-current side of each alternating-current inverter 12.

One end of the transformer 15 is connected to the alternating-current side of each alternating-current inverter 12, and the other end (including a terminal L1, a terminal L2 and a terminal L3) of the transformer 15 is connected to the power grid.

In step S102, when it is monitored that alternating-current insulation resistance meets a preset normal alternating-current resistance condition, and when the inverter operates and meets a grid-connected condition, direct-current insulation monitoring is performed before the inverter is connected to the power grid.

The alternating-current insulation resistance meeting the preset normal alternating-current resistance condition indicates that the alternating-current insulation is normal and no alternating-current insulation fault occurs. The preset normal alternating-current resistance condition indicates a range of the alternating-current insulation resistance when the alternating-current insulation is normal. This range is set as required and thus is not limited in the present disclosure.

In the embodiment, the inverter is not connected to the power grid immediately when the alternating-current insulation is normal and the inverter meets the grid-connected condition, until the direct-current insulation monitoring is already performed. That is, the inverter is controlled to be connected to the power grid only when the direct-current insulation monitored by the direct-current insulation monitoring device is normal.

In step S103, when it is monitored that direct-current insulation resistance meets a preset normal direct-current resistance condition, the inverter is controlled to be connected to the power grid, and the alternating-current insulation monitoring and the direct-current insulation monitoring are stopped. The anti-PID device and the alternating-current insulation monitoring device are controlled to alternately operate in the period during which the inverter is connected to the power grid.

The direct-current insulation resistance meeting the preset normal direct-current resistance condition indicates that the direct-current insulation is normal and no direct-current insulation fault occurs. Then, the inverter is controlled to perform a switch from shutdown to grid-connection, and the alternating-current insulation monitoring and the direct-current insulation monitoring are stopped.

The preset normal direct-current resistance condition indicates a range of the direct-current insulation resistance when the direct-current insulation is normal. This range is set as required and thus is not limited in the present disclosure.

In practice, in the period during which the inverter is connected to the power grid, the anti-PID device and alternating-current insulation monitoring device are controlled to alternately operate in such a way that the anti-PID device operates and then the alternating-current insulation monitoring device operates or that the alternating-current insulation monitoring device operates and then the anti-PID device operates, depending on actual situations, which is not limited in the present disclosure.

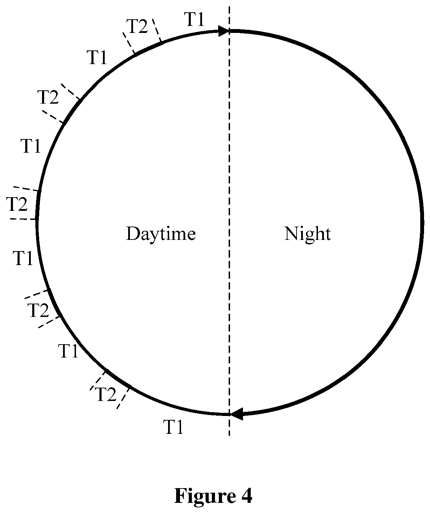

Reference is made to Figure 4, which is a schematic diagram showing that the anti-PID device and the insulation monitoring device alternately operate around the clock according to an embodiment of the present disclosure. The alternation varies from daytime to nighttime. Throughout the nighttime, the photovoltaic panel does not operate due to no sunlight, the inverter is shut down in order to reduce energy consumption, and the insulation monitoring is still performed in order that the insulation monitoring can be performed around the clock. For details of the insulation monitoring, reference is made to steps S101 and S102.

The alternating-current insulation monitoring and the direct-current insulation monitoring are stopped when the inverter is already connected to the power grid. Meanwhile, the anti-PID device is controlled to start operating, and a timer starts timekeeping. When the timer counts up to T1, the anti-PID device stops operating to cut off a ground loop and the alternating-current insulation monitoring starts operating until T2 elapses. If it is monitored that the alternating-current insulation resistance is normal, the alternating-current insulation monitoring stops, and the anti-PID device resumes operating, so that the anti-PID device and the alternating-current insulation monitoring device alternately operate (reference is made to Figure 4 which illustrates that T1s alternate with T2s). In practice, the timer counts up to a preset period of time when the anti-PID device and the alternating-current insulation monitoring device already alternately operate one time, and then the timer starts the timekeeping from zero. The preset period of time includes T1 throughout which the anti-PID device operates and T2 throughout which the insulation alternating-current insulation monitoring device operates.

It should be noted that when the inverter is shut down, the alternating-current side is physically isolated from the direct-current side. The alternating-current insulation monitoring and the direct-current insulation monitoring are performed by respective devices, namely, the alternating-current insulation monitoring device and the direct-current insulation monitoring device. The alternating-current insulation monitoring device and the direct-current insulation monitoring device operate differently. The direct-current insulation monitoring device operates only when the inverter is shut down. The alternating-current insulation monitoring device operates when the inverter is shut down and when the inverter is connected to the power grid.

In summary, the method for insulation monitoring is provided according to the present disclosure. When it is monitored that the inverter is shut down, the alternating-current insulation monitoring device is controlled to constantly perform alternating-current insulation monitoring at the alternating-current side. When it is monitored that alternating-current insulation resistance meets the preset normal alternating-current resistance condition and when the inverter operates and meets the grid-connected condition, the direct-current insulation monitoring is performed before the inverter is connected to the power grid. When it is monitored that direct-current insulation resistance meets the preset normal direct-current resistance condition, the inverter is controlled to be connected to the power grid, and the alternating-current insulation monitoring and the direct-current insulation monitoring are stopped. Further, the anti-PID device and the alternating-current insulation monitoring device are controlled to alternately operate in the period during which the inverter is connected to the power grid. Normally, the inverter is shut down throughout the nighttime and is connected to the power grid throughout the daytime. In view of this, the anti-PID device and the insulation monitoring device alternately operate depending on whether the inverter is shut down or connected to the power grid according to the present disclosure. In the period during which the inverter is shut down, the alternating-current insulation monitoring device constantly performs the alternating-current insulation monitoring. In the period during which the inverter is connected to the power grid, the anti-PID device and the alternating-current insulation monitoring device alternately operate with the anti-PID device operates first, so that the anti-PID can be compatible with the alternating-current insulation monitoring. Therefore, the insulation monitoring can be performed around the clock while preventing the PID according to the present disclosure, thereby solving the problem that the insulation monitoring device fails to operate around the clock currently.

In addition, only the control device is controlled in a manner different from the existing manner and no change is made to the existing inverter system according to the present disclosure. Therefore, the cost is low and the implementation is convenient.

It should be further noted that the present disclosure is applicable to any type of insulation monitoring device.

In order to further optimize the above embodiments, insulation fault detection and location are further performed in the period during which the inverter is shut down and the period during which the inverter is connected to the power grid.

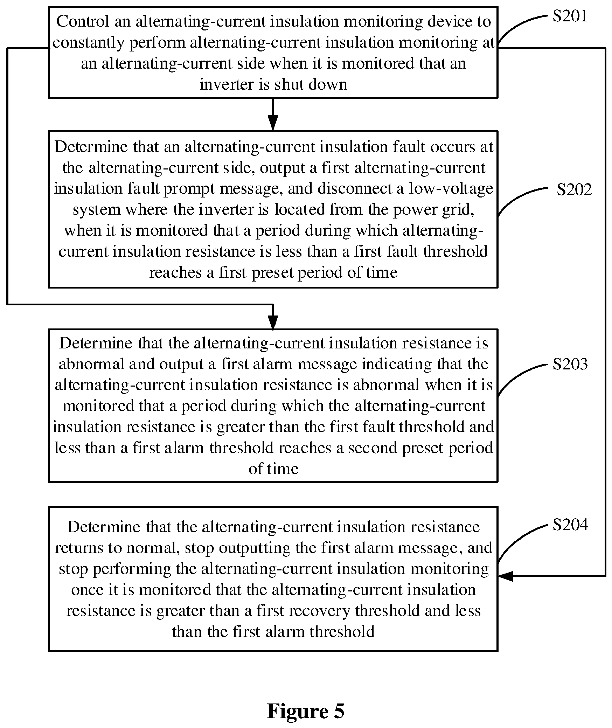

Reference is made to Figure 5, which is a flow chart illustrating a method for insulation monitoring performed in the period during which the inverter is shut down according to an embodiment of the present disclosure. The method includes the following steps S201 to S204.

In step S201, when it is monitored that the inverter is shut down, the alternating-current insulation monitoring device is controlled to constantly perform alternating-current insulation monitoring at the alternating-current side.

In step S202, when it is monitored that a period during which the alternating-current insulation resistance is less than a first fault threshold reaches a first preset period of time, it is determined that an alternating-current insulation fault occurs at the alternating-current side, a first alternating-current insulation fault prompt message is outputted, and the low-voltage system where the inverter is located is disconnected from the power grid.

In a case that the period during which the alternating-current insulation resistance monitored by the alternating-current insulation monitoring device is less than the first fault threshold reaches the first period of time, it is determined that the alternating-current insulation resistance is relatively low and the alternating-current insulation fault occurs at the alternating-current side. In such case, the first alternating-current insulation fault prompt message is outputted to report the fault, and the low-voltage system where the inverter is located is disconnected from the power grid, so as to remove the alternating-current insulation fault.

In practice, the alternating-current insulation fault may be removed by switching off a vacuum circuit breaker (VCB) in a ring main unit arranged between the inverter and the power grid.

The first fault threshold and the first preset period of time are set as required and thus are not limited in the present disclosure.

In step S203, when it is monitored that a period during which the alternating-current insulation resistance is greater than the first fault threshold and less than a first alarm threshold reaches a second preset period of time, it is determined that the alternating-current insulation resistance is abnormal, and a first alarm message indicating that the alternating-current insulation resistance is abnormal is outputted.

The first fault threshold is less than the first alarm threshold. The first fault threshold, the first alarm threshold and the second preset period of time are set as required and thus are not limited in the present disclosure.

In step S204, once it is monitored that the alternating-current insulation resistance is greater than a first recovery threshold and less than the first alarm threshold, it is determined that the alternating-current insulation resistance returns to normal, the first alarm message stops being outputted, and the alternating-current insulation resistance stops being performed.

The first recovery threshold in the embodiment is a smallest limit when the alternating-current insulation resistance is normal, is set as required and thus is not limited in the present disclosure.

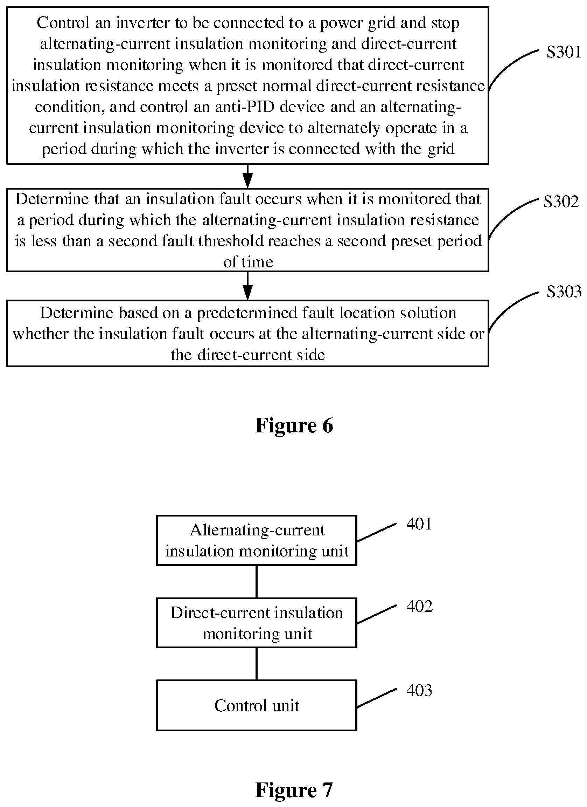

Reference is made to Figure 6, which is a flow chart illustrating a method for insulation monitoring performed in the period during which the inverter is connected to the power grid according to an embodiment of the present disclosure. The method includes the following step S301 to S303.

In step S301, when it is monitored that the direct-current insulation resistance meets the preset normal direct-current resistance condition, the inverter is controlled to be connected to the power grid, the alternating-current insulation monitoring and the direct-current insulation monitoring are stopped. Further, the anti-PID device and the alternating-current insulation monitoring device are controlled to alternately operate in the period during which the inverter is connected to the power grid.

In step S302, when it is monitored that a period during which the alternating-current insulation resistance is less than a second fault threshold reaches a second preset period of time, it is determined that an insulation fault occurs.

In step S303, it is determined based on a predetermined fault location solution whether the insulation fault occurs at the alternating-current side or the direct-current side.

When it is monitored that the alternating-current insulation resistance is less than the second fault threshold, the alternating-current insulation monitoring is constantly performed in order to avoid false determination, without considering whether the insulation monitoring timed by the timer already lasts for T2. Only when the period during which the alternating-current insulation resistance is less than the second fault threshold reaches the second preset period of time, it is determined that the insulation fault occurs, and the fault location is performed subsequently. If the period during which the alternating-current insulation resistance is lower than the second fault threshold is less than the second preset period of time, the subsequent process still depends on the duration timed by the timer.

It should be noted that in the embodiment, the fault location solution is mainly for determining whether the insulation fault occurs at the alternating-current side or the direct-current side. The fault location solution is as follows.

The inverter is controlled to be shut down and the direct-current insulation monitoring is triggered. In a case that insulation resistance of a positive pole of the photovoltaic string to ground or insulation resistance of a negative pole of the photovoltaic string to ground is less than a protection threshold, it is determined that the insulation fault occurs at the direct-current side.

In addition, the alternating-current insulation monitoring is triggered. If it is monitored that the alternating-current insulation resistance is less than a third fault threshold, it is determined that the insulation fault occurs at the alternating-current side.

The protection threshold and the third fault threshold are set as required, and thus are not limited in the present disclosure.

In a case that the insulation fault occurs at the alternating-current side, a second alternating-current insulation fault prompt message is outputted, and the low-voltage system where the inverter is located is disconnected from the power grid.

In the embodiment, in the case that the insulation fault occurs at the alternating-current side, that is, an alternating-current insulation fault occurs, the second alternating-current insulation fault prompt message is outputted to report the fault and the low-voltage system where the inverter is located is disconnected from the power grid so as to remove the alternating-current insulation fault.

In practice, the alternating-current insulation fault is removed by switching off a VCB in the ring main unit arranged between the inverter and the power grid.

In response to failure in disconnecting the low-voltage system from the power grid, the inverter is controlled to stop operating, and the insulation monitoring is constantly performed. When the insulation fault (the alternating-current or direct-current insulation fault) is removed already, the second alternating-current insulation fault prompt message stops being outputted.

In the embodiment, if the VCB in the ring main unit fails to be switched off, the insulation monitoring is constantly performed in the period during which the inverter stops operating. When the insulation fault is successfully removed, the second alternating-current insulation fault prompt message stops being outputted, and the inverter resumes operating so as to connected to the power grid.

It should be noted that the number of times that the insulation resistance returns to normal is allowed to be not exceed a preset number of times in one day. In a case that the number of times of the insulation resistance returns to normal exceeds the preset number of times, it is determined that an insulation fault occurs, and the insulation resistance no longer returns to normal.

In the period during which the inverter is connected to the power grid, it is determined that the alternating-current insulation resistance is abnormal and a second alarm message indicating that the alternating-current insulation resistance is abnormal is outputted when it is monitored that a period during which the alternating-current insulation resistance is greater than the second fault threshold and less than a second alarm threshold reaches a third preset period of time.

The second fault threshold is less than the second alarm threshold, and the second fault threshold, the second alarm threshold and the third predetermined time period are set as required and thus are not limited in the present disclosure.

In the embodiment, in the period during which the inverter is connected to the grid, the alternating-current insulation monitoring is constantly performed when it is monitored that the alternating-current insulation resistance is greater than the second fault threshold and lower than the second alarm threshold in order to avoid false determination, without considering whether the insulation monitoring timed by the timer already lasts for T2. Only when it is monitored that the period during which the alternating-current insulation resistance is greater than the second fault threshold and less than the second alarm threshold reaches the third preset period of time, it is determined that the alternating-current insulation resistance is abnormal and the second alarm message indicating that the alternating-current insulation resistance is abnormal is outputted.

In the period during which the inverter is connected to the power grid, it is determined that the alternating-current insulation resistance returns to normal, the second alarm message stops being outputted, and the alternating-current insulation monitoring stops being performed once it is monitored that the alternating-current insulation resistance is greater than the second alarm threshold and less than the second alarm threshold.

The second alarm threshold is set as required, and thus is not limited in the present disclosure.

In the period during which the inverter is connected to the power grid, the timer for the insulation monitoring is reset and the alternating-current insulation monitoring is forced to be constantly performed when it is monitored that an alarm indicator indicating low insulation resistance is valid.

When it is monitored that the alternating-current insulation resistance is greater than a second recovery threshold for a preset alternating-current insulation alarm recovery time period, it is determined that the alternating-current insulation resistance returns to normal, the alarm indicator indicating low insulation resistance is changed to be invalid, and the alternating-current insulation monitoring stops being performed.

The preset alternating-current insulation alarm recovery time period is set as required, for example, 10min, and thus is not limited in the present disclosure.

The second recovery threshold is set as required, for example, 20k, and thus is not limited in the present disclosure.

It should be noted that in the period during which the inverter is connected to the grid, the insulation monitoring is performed as the case that the inverter is shut down in a case that the inverter stops operating or other fault than an insulation fault occurs in the inverter. That is, in the period during which the inverter is connected to the grid, the timer is reset and the insulation monitoring is switched from a mode that the inverter is connected to the grid to a mode that the inverter is shut down, when the inverter stops operating or other fault than an insulation fault (that is, a fault other than the fault shown in the present disclosure) occurs in the inverter. The insulation monitoring corresponding to the case that the inverter is shut down is as shown in Figure 5. The insulation monitoring corresponding to the case that the inverter is connected to the grid is as shown in Figure 6.

Corresponding to the above method embodiments, an apparatus for insulation monitoring is further provided according to an embodiment of the present disclosure.

Reference is made to Figure 7, which is a schematic structural diagram illustrating the apparatus for insulation monitoring according to an embodiment of the present disclosure. The apparatus is applied to the control device in a system for generating electricity from renewable energy. The apparatus includes an alternating-current insulation monitoring unit 401, a direct-current insulation monitoring unit 402, and a control unit 403.

The alternating-current insulation monitoring unit 401 is configured to control, when it is monitored that an inverter is shut down, an alternating-current insulation monitoring device to constantly perform alternating-current insulation monitoring at an alternating-current side.

In practice, the inverter is shut down when an alternating-current switch inside the inverter is switched off, and alternating-current ground isolation is decoupled from direct-current ground isolation. The alternating-current insulation monitoring device constantly performs the alternating-current insulation monitoring at the alternating-current side.

The alternating-current insulation monitoring unit 401 is configured to: control the alternating-current insulation monitoring device to constantly perform the alternating-current insulation monitoring at the alternating-current side when it is monitored that the inverter is shut down in a case that the anti-PID device is arranged at the alternating-current side; and control the alternating-current insulation monitoring device to constantly perform alternating-current insulation monitoring at the alternating-current side and control the anti-PID device to operate (according to the original settings) at a direct-current side when it is monitored that the inverter is shut down in a case that the anti-PID device is arranged at the direct-current side. In the latter case, the direct-current side is independent of the alternating-current side.

The direct-current insulation monitoring unit 402 is configured to perform, when it is monitored that alternating-current insulation resistance meets a preset normal alternating-current resistance condition and that the inverter operates and meets a grid-connected condition, direct-current insulation monitoring before the inverter is connected to the power grid.

The alternating-current insulation resistance meeting the preset normal alternating-current resistance condition indicates that the alternating-current insulation is normal and no alternating-current insulation fault occurs. The preset normal alternating-current resistance condition indicates a range of the alternating-current insulation resistance when the alternating-current insulation is normal. This range depends on the actual requirements, and thus is not limited in the present disclosure.

In the embodiment, the inverter is not connected to the power grid immediately when the alternating-current insulation is normal and the inverter meets the grid-connected condition, until the direct-current insulation monitoring is already performed. That is, the inverter is controlled to be connected to the power grid only when the direct-current insulation monitored by the direct-current insulation monitoring device is normal.

The control unit 403 is configured to: control the inverter to be connected to the power grid and stop the alternating-current insulation monitoring and the direct-current insulation monitoring when it is monitored that direct-current insulation resistance meets a preset normal direct-current resistance condition; and control an anti-PID device and the alternating-current insulation monitoring device to alternately operate in a period during which the inverter is connected to the power grid.

The direct-current insulation resistance meeting the preset normal direct-current resistance condition indicates that the direct-current insulation is normal and no direct-current insulation fault occurs. Then, the inverter is controlled to perform a switch from shutdown to grid-connection, and the alternating-current insulation monitoring and the direct-current insulation monitoring are stopped.

The preset normal direct-current resistance condition indicates a range of the direct-current insulation resistance when the direct-current insulation is normal. This range is set as required and thus is not limited in the present disclosure.

Details about the anti-PID device and the insulation monitoring device operating alternately around the clock may refer to the method embodiments referring to Figure 4, and thus are not repeated here.

It should be noted that when the inverter is shut down, the alternating-current side is physically isolated from the direct-current side. The alternating-current insulation monitoring and the direct-current insulation monitoring are performed by respective devices, namely, the alternating-current insulation monitoring device and the direct-current insulation monitoring device. The alternating-current insulation monitoring device and the direct-current insulation monitoring device operate differently. The direct-current insulation monitoring device operates only when the inverter is shut down. The alternating-current insulation monitoring device operates when the inverter is shut down and when the inverter is connected to the power grid.

In summary, the apparatus for insulation monitoring is provided according to the present disclosure. When it is monitored that the inverter is shut down, the alternating-current insulation monitoring device is controlled to constantly perform alternating-current insulation monitoring at the alternating-current side. When it is monitored that alternating-current insulation resistance meets the preset normal alternating-current resistance condition and when the inverter operates and meets the grid-connected condition, the direct-current insulation monitoring is performed before the inverter is connected to the power grid. When it is monitored that direct-current insulation resistance meets the preset normal direct-current resistance condition, the inverter is controlled to be connected to the power grid, and the alternating-current insulation monitoring and the direct-current insulation monitoring are stopped. Further, the anti-PID device and the alternating-current insulation monitoring device are controlled to alternately operate in the period during which the inverter is connected to the power grid. Normally, the inverter is shut down throughout the nighttime and is connected to the power grid throughout the daytime. In view of this, the anti-PID device and the insulation monitoring device alternately operate depending on whether the inverter is shut down or connected to the power grid according to the present disclosure. In the period during which the inverter is shut down, the alternating-current insulation monitoring device constantly performs the alternating-current insulation monitoring. In the period during which the inverter is connected to the power grid, the anti-PID device and the alternating-current insulation monitoring device alternately operate with the anti-PID device operates first, so that the anti-PID can be compatible with the alternating-current insulation monitoring. Therefore, the insulation monitoring can be performed around the clock while preventing the PID according to the present disclosure, thereby solving the problem that the insulation monitoring device fails to operate around the clock currently.

In addition, only the control device is controlled in a manner different from the existing manner and no change is made to the existing inverter system according to the present disclosure. Therefore, the cost is low and the implementation is convenient.

It should be further noted that the present disclosure is applicable to any type of insulation monitoring device.

In order to further optimize the above embodiments, insulation fault detection and location are further performed in the period during which the inverter is shut down and the period during which the inverter is connected to the power grid.

In view of this, the apparatus for insulation monitoring further includes an inverter shutdown fault detection unit.

The inverter shutdown fault detection unit is configured to determine that an alternating-current insulation fault occurs at the alternating-current side, output a first alternating-current insulation fault prompt message, and disconnect a low-voltage system where the inverter is located from the power grid when it is monitored in the period during which the inverter is shut down that a period during which the alternating-current insulation resistance is less than a first fault threshold reaches a first preset period of time.

The inverter shutdown fault detection unit is further configured to determine that the alternating-current insulation resistance is abnormal and output a first alarm message indicating that the alternating-current insulation resistance is abnormal when it is monitored in the period during which the inverter is shut down that a period during which the alternating-current insulation resistance is greater than the first fault threshold and less than a first alarm threshold reaches a second preset period of time.

The inverter shutdown fault detection unit is further configured to determine that the alternating-current insulation resistance returns to normal, stop outputting the first alarm message, and stop the alternating-current insulation monitoring once it is monitored that the alternating-current insulation resistance is greater than a first recovery threshold and less than the first alarm threshold in the period during which the inverter is shut down.

In order to further optimize the above embodiments, the apparatus for insulation monitoring further includes an inverter grid-connection fault detection unit and a fault location unit.

The inverter grid-connection fault detection unit is configured to determine that an insulation fault occurs when it is monitored in the period during which the inverter is connected to the power grid that a period during which the alternating-current insulation resistance is less than a second fault threshold reaches a second preset period of time.

The fault location unit is configured to determine, based on a predetermined fault location solution, whether the insulation fault occurs at the alternating-current side or the direct-current side.

The fault location unit is configured to: control the inverter to be shut down and trigger the direct-current insulation monitoring, and determine that the insulation fault occurs at the direct-current side in a case that insulation resistance of a positive pole of the photovoltaic string to ground or insulation resistance of a negative pole of the photovoltaic string to ground is less than a protection threshold; and trigger the alternating-current insulation monitoring, and determine that the insulation fault occurs at the alternating-current side when it is monitored that the alternating-current insulation resistance is less than a third fault threshold.

The fault location unit is further configured to output a second alternating-current insulation fault prompt message and disconnect the low-voltage system where the inverter is located from the power grid in a case that the insulation fault occurs at the alternating-current side.

The fault location unit is further configured to control the inverter to stop operating and constantly monitor the insulation resistance in response to failure in disconnecting the low-voltage system from the power grid; and stop outputting the second alternating-current insulation fault prompt message and control the inverter to resume operating so as to be connected to the power grid when the insulation fault is successfully removed.

In order to further optimize the above embodiments, the inverter grid-connection fault detection unit is further configured to determine that the alternating-current insulation resistance is abnormal and output a second alarm message indicating that the alternating-current insulation resistance is abnormal when it is monitored in the period during which the inverter is connected to the power grid that a period during which the alternating-current insulation resistance is greater than the second fault threshold and less than a second alarm threshold reaches a third preset period of time.

In order to further optimize the above embodiments, the inverter grid-connection fault detection unit is further configured to determine that the alternating-current insulation resistance returns to normal, stop outputting the second alarm message, and stop the alternating-current insulation monitoring once it is monitored that the alternating-current insulation resistance is greater than the second alarm threshold and less than the second alarm threshold in the period during which the inverter is connected to the power grid.

In order to further optimize the above embodiments, the inverter grid-connection fault monitoring unit is further configured to, in the period during which the inverter is connected to the power grid: reset a timer for the insulation monitoring and constantly perform alternating-current insulation monitoring forcefully when it is monitored that an alarm indicator indicating low insulation resistance is valid; and determine that the alternating-current insulation resistance returns to normal, change the alarm indicator indicating low insulation resistance to be invalid, and stop performing the alternating-current insulation monitoring when it is monitored that the alternating-current insulation resistance is greater than a second recovery threshold for a preset alternating-current insulation alarm recovery time period.

The apparatus for insulation monitoring further includes a switching unit.

The switching unit is configured to switch, when the inverter stops operating or other fault than an insulation fault occurs in the inverter in the period during which the inverter is connected to the grid, the insulation monitoring from a mode that the inverter is connected to the power grid to a mode that the inverter is shut down.

It should be noted that details about components of the apparatus for insulation monitoring can refer to the method embodiments, and thus are not described herein.

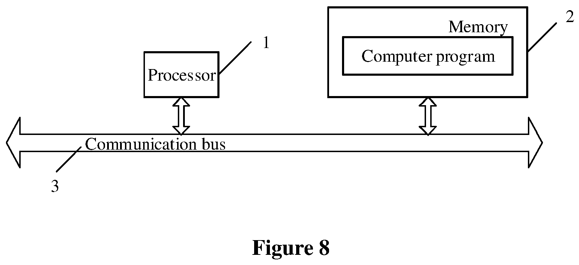

A system for generating electricity from renewable energy is further provided according to an embodiment of the present disclosure. The system for generating electricity from renewable energy includes an anti-PID device, an alternating-current insulation monitoring device and a control device. The control device shown in Figure 8 includes a processor 1, a memory 2, and a computer program stored in the memory 2 and executable by the processor.

The processor 1 communicates with the memory 2 through a communication bus 3.

The processor 1 may be a central processing unit (CPU), or an application specific integrated circuit (ASIC), or one or more integrated circuits configured to implement embodiments of the present disclosure.

The memory 2 may include a high-speed RAM memory, or may further include a non-volatile memory, for example, at least one disk memory.

The processor 1, when executing the computer program, controls an alternating-current insulation monitoring device to constantly perform alternating-current insulation monitoring at an alternating-current side when it is monitored that an inverter is shut down; performs direct-current insulation monitoring before the inverter is connected to a power grid when it is monitored that alternating-current insulation resistance meets a preset normal alternating-current resistance condition and the inverter meets a grid-connected condition; controls the inverter to be connected to the power grid and stops the alternating-current insulation monitoring and the direct-current insulation monitoring when it is monitored that direct-current insulation resistance meets a preset normal direct-current resistance condition; and controls an anti-PID device and the alternating-current insulation monitoring device to alternately operate in a period during which the inverter is connected to the power grid.

In summary, the system for generating electricity from renewable energy is provided according to the present disclosure. The control device in the system for generating electricity from renewable energy controls the alternating-current insulation monitoring device to constantly perform alternating-current insulation monitoring at the alternating-current side and controls the anti-PID device to operate at the direct-current side when it is monitored that the inverter is shut down. When it is monitored that alternating-current insulation resistance meets the preset normal alternating-current resistance condition and when the inverter operates and meets the grid-connected condition, the direct-current insulation monitoring is performed before the inverter is connected to the power grid. When it is monitored that direct-current insulation resistance meets the preset normal direct-current resistance condition, the inverter is controlled to be connected to the power grid, and the alternating-current insulation monitoring and the direct-current insulation monitoring are stopped. Further, the anti-PID device and the alternating-current insulation monitoring device are controlled to alternately operate in the period during which the inverter is connected to the power grid. Normally, the inverter is shut down throughout the nighttime and is connected to the power grid throughout the daytime. In view of this, the anti-PID device and the insulation monitoring device alternately operate depending on whether the inverter is shut down or connected to the power grid according to the present disclosure. In the period during which the inverter is shut down, the alternating-current insulation monitoring device constantly performs the alternating-current insulation monitoring. In the period during which the inverter is connected to the power grid, the anti-PID device and the alternating-current insulation monitoring device alternately operate with the anti-PID device operates first, so that the anti-PID can be compatible with the alternating-current insulation monitoring. Therefore, the insulation monitoring can be performed around the clock while preventing the PID according to the present disclosure, thereby solving the problem that the insulation monitoring device fails to operate around the clock currently.

## Claims

1. A method for insulation monitoring, comprising:
controlling (S101) an alternating-current insulation monitoring device (14) to constantly perform alternating-current insulation monitoring at an alternating-current side of an inverter (12);
performing (S102) direct-current insulation monitoring at a direct-current side of the inverter (12)
**characterised in that**
the alternating-current insulation monitoring at the alternating-current side of the inverter (12) is constantly performed when it is monitored that the inverter (12) is shut down;
the direct-current insulation monitoring at the direct-current side of the inverter (12) is performed before the inverter (12) is connected to a power grid when it is monitored that alternating-current insulation resistance meets a preset normal alternating-current resistance condition and that the inverter (12) operates and meets a grid-connected condition; and
controlling (S103) the inverter (12) to be connected to the power grid and stopping the alternating-current insulation monitoring and the direct-current insulation monitoring when it is monitored that direct-current insulation resistance meets a preset normal direct-current resistance condition, and controlling an anti-potential-induced-degradation, anti-PID, device (13) and the alternating-current insulation monitoring device (14) to alternately operate in a period during which the inverter (12) is connected to the power grid.

2. The method for insulation monitoring according to claim 1, further comprising:
determining (S202) that an alternating-current insulation fault occurs at the alternating-current side, outputting a first alternating-current insulation fault prompt message and disconnecting a low-voltage system where the inverter (12) is located, from the power grid, when it is monitored that a period during which the alternating-current insulation resistance is less than a first fault threshold reaches a first preset period of time, in a case that the inverter (12) is shut down.

3. The method for insulation monitoring according to claim 2, further comprising:
determining (S203) that the alternating-current insulation resistance is abnormal and outputting a first alarm message indicating that the alternating-current insulation resistance is abnormal when it is monitored that a period during which the alternating-current insulation resistance is greater than the first fault threshold and less than a first alarm threshold reaches a second preset period of time, in a case that the inverter (12) is shut down.

4. The method for insulation monitoring according to claim 3, further comprising:
determining (S204) that the alternating-current insulation resistance returns to normal, stopping outputting the first alarm message and stopping the alternating-current insulation monitoring once it is monitored that the alternating-current insulation resistance is greater than a first recovery threshold and less than the first alarm threshold, in a case that the inverter (12) is shut down.

5. The method for insulation monitoring according to claim 1, further comprising:
determining (S302) that an insulation fault occurs when it is monitored that a period during which the alternating-current insulation resistance is less than a second fault threshold reaches a second preset period of time and determining based on a predetermined fault location solution whether the insulation fault occurs at the alternating-current side or the direct-current side, in the period during which the inverter (12) is connected to the power grid.

6. The method for insulation monitoring according to claim 5, wherein the determining based on a predetermined fault location solution whether the insulation fault occurs at the alternating-current side or the direct-current side comprises:
controlling the inverter (12) to be shut down and triggering the direct-current insulation monitoring, and determining that the insulation fault occurs at the direct-current side in a case that insulation resistance of a positive pole of a photovoltaic string to ground or insulation resistance of a negative pole of the photovoltaic string to ground is less than a protection threshold; and
triggering the alternating-current insulation monitoring, and determining that the insulation fault occurs at the alternating-current side when it is monitored that the alternating-current insulation resistance is less than a third fault threshold.

7. The method for insulation monitoring according to claim 6, further comprising:
outputting a second alternating-current insulation fault prompt message and disconnecting a low-voltage system where the inverter (12) is located, from the power grid, when it is determined that the insulation fault occurs at the alternating-current side.

8. The method for insulation monitoring according to claim 7, further comprising:
controlling the inverter (12) to stop operating and constantly performing insulation monitoring in response to failure in the disconnecting the low-voltage system from the power grid; and
stopping outputting the second alternating-current insulation fault prompt message and controlling the inverter (12) to resume operating so as to be connected to the power grid when the insulation fault is successfully removed.

9. The method for insulation monitoring according to claim 5, further comprising:
determining (S203) that the alternating-current insulation resistance is abnormal and outputting a second alarm message indicating that the alternating-current insulation resistance is abnormal when it is monitored that a period during which the alternating-current insulation resistance is greater than the second fault threshold and less than a second alarm threshold reaches a third preset period of time, in the period during which the inverter (12) is connected to the power grid.

10. The method for insulation monitoring according to claim 9, further comprising:
determining (S204) that the alternating-current insulation resistance returns to normal, stopping outputting the second alarm message and stopping performing the alternating-current insulation monitoring once it is monitored that the alternating-current insulation resistance is greater than the second alarm threshold, in the period during which the inverter (12) is connected to the power grid.

11. The method for insulation monitoring according to claim 1, further comprising:
in the period during which the inverter (12) is connected to the power grid, resetting a timer for the insulation monitoring and constantly performing the alternating-current insulation monitoring forcefully when it is monitored that an alarm indicator indicating low insulation resistance is valid; and determining that the alternating-current insulation resistance returns to normal, changing the alarm indicator indicating low insulation resistance to be invalid and stopping performing the alternating-current insulation monitoring when it is monitored that a period during which the alternating-current insulation resistance is greater than a second recovery threshold reaches a preset alternating-current insulation alarm recovery time period.

12. The method for insulation monitoring according to claim 1, further comprising:
switching, when the inverter (12) stops or a fault other than an insulation fault occurs in the inverter (12) in the period during which the inverter (12) is connected to the grid, the insulation monitoring from a mode that the inverter (12) is connected to the power grid to a mode that the inverter (12) is shut down, in the period during which the inverter (12) is connected to the grid.

13. The method for insulation monitoring according to claim 1, wherein the controlling the alternating-current insulation monitoring device (14) to constantly perform alternating-current insulation monitoring at the alternating-current side of the inverter (12) when it is monitored that the inverter (12) is shut down comprises:
controlling the alternating-current insulation monitoring device (14) to constantly perform the alternating-current insulation monitoring at the alternating-current side and controlling the anti-PID device (13) to stop operating, when it is monitored that the inverter (12) is shut down in a case that the anti-PID device (13) is arranged at the alternating-current side; or
controlling the alternating-current insulation monitoring device (14) to constantly perform the alternating-current insulation monitoring at the alternating-current side and controlling the anti-PID device (13) to operate at the direct-current side, when it is monitored that the inverter (12) is shut down in a case that the anti-PID device (13) is arranged at the direct-current side.

14. An apparatus for insulation monitoring, comprising:
an alternating-current insulation monitoring unit (401) configured to control an alternating-current insulation monitoring device (14) to constantly perform alternating-current insulation monitoring at an alternating-current side of an inverter (12);
a direct-current insulation monitoring unit (402) configured to perform direct-current insulation monitoring at a direct-current side of the inverter (12)
**characterised in that**
the alternating-current insulation monitoring unit (401) is configured to control the alternating-current insulation monitoring device (14) to constantly perform the alternating-current monitoring at the alternating-current side of the inverter (12) when it is monitored that the inverter (12) is shut down;
the direct-current monitoring unit (402) is configured to perform the direct-current insulation monitoring at the direct-current side of the inverter (12) before the inverter (12) is connected to a power grid when it is monitored that alternating-current insulation resistance meets a preset normal alternating-current resistance condition and that the inverter (12) operates and meets a grid-connected condition; and
a control unit (403) configured to control the inverter (12) to be connected to the power grid and stop the alternating-current insulation monitoring and the direct-current insulation monitoring when it is monitored that direct-current insulation resistance meets a preset normal direct-current resistance condition, and control an anti-potential-induced-degradation, anti-PID, device (13) and the alternating-current insulation monitoring device (14) to alternately operate in a period during which the inverter (12) is connected to the power grid.

15. A system for generating electricity from renewable energy, comprising:
an anti-potential-induced-degradation, anti-PID, device (13);
an alternating-current insulation monitoring device (14); and
a control device comprising a processor (1), a memory (2), and a computer program stored in the memory (2) and executable by the processor (1), wherein the processor (1) is configured to execute the computer program to perform the method for insulation monitoring according to any one of claims 1 to 13.

## Patentansprüche

1. Verfahren zur Isolationsüberwachung, umfassend:
Steuern (S101) einer Wechselstrom-Isolationsüberwachungsvorrichtung (14), um kontinuierlich eine Wechselstrom-Isolationsüberwachung auf einer Wechselstromseite eines Wechselrichters (12) durchzuführen;
Durchführen (S102) einer Gleichstrom-Isolationsüberwachung auf einer Gleichstromseite des Wechselrichters (12)
**dadurch gekennzeichnet, dass**
die Wechselstrom-Isolationsüberwachung auf der Wechselstromseite des Wechselrichters (12) kontinuierlich durchgeführt wird, wenn überwacht wird, dass der Wechselrichter (12) abgeschaltet ist;
die Gleichstrom-Isolationsüberwachung auf der Gleichstromseite des Wechselrichters (12) durchgeführt wird, bevor der Wechselrichter (12) mit einem Stromnetz verbunden wird, wenn überwacht wird, dass der Wechselstrom-Isolationswiderstand eine voreingestellte normale Wechselstrom-Widerstandsbedingung erfüllt und dass der Wechselrichter (12) in Betrieb ist und eine Netzverbindungsbedingung erfüllt; und
Steuern (S103) des Wechselrichters (12), der mit dem Stromnetz verbunden werden soll, und Beenden der Wechselstrom-Isolationsüberwachung und der Gleichstrom-Isolationsüberwachung, wenn überwacht wird, dass der Gleichstrom-Isolationswiderstand eine voreingestellte normale Gleichstrom-Widerstandsbedingung erfüllt, und Steuern einer Anti-Potential-induzierte-Degradations-, Anti-PID-, Vorrichtung (13), und einer Wechselstrom-Isolationsüberwachungsvorrichtung (14), um abwechselnd in einem Zeitraum in Betrieb zu sein, in dem der Wechselrichter (12) mit dem Stromnetz verbunden ist.

2. Verfahren zur Isolationsüberwachung nach Anspruch 1, weiter umfassend:
Bestimmen (S202), dass ein Wechselstrom-Isolationsfehler auf der Wechselstromseite auftritt, Ausgeben einer ersten Wechselstrom-Isolationsfehler-Warnmeldung und Trennen eines Niederspannungssystems, in dem sich der Wechselrichter (12) befindet, vom Stromnetz, wenn überwacht wird, dass ein Zeitraum, in dem der Wechselstrom-Isolationswiderstand kleiner als ein erster Fehlerschwellenwert ist, eine erste voreingestellte Zeitspanne erreicht, in einem Fall, in dem der Wechselrichter (12) abgeschaltet ist.

3. Verfahren zur Isolationsüberwachung nach Anspruch 2, weiter umfassend:
Bestimmen (S203), dass der Wechselstrom-Isolationswiderstand abnormal ist, und Ausgeben einer ersten Alarmmeldung, die angibt, dass der Wechselstrom-Isolationswiderstand abnormal ist, wenn überwacht wird, dass ein Zeitraum, in dem der Wechselstrom-Isolationswiderstand größer als der erste Fehlerschwellenwert und kleiner als ein erster Alarmschwellenwert ist, eine zweite voreingestellte Zeitspanne erreicht, in einem Fall, in dem der Wechselrichter (12) abgeschaltet ist.

4. Verfahren zur Isolationsüberwachung nach Anspruch 3, weiter umfassend:
Bestimmen (S204), dass der Wechselstrom-Isolationswiderstand wieder zu normal zurückkehrt, Beenden des Ausgebens der ersten Alarmmeldung und Beenden der Wechselstrom-Isolationsüberwachung, sobald überwacht wird, dass der Wechselstrom-Isolationswiderstand größer als ein erster Wiederherstellungsschwellenwert und kleiner als der erste Alarmschwellenwert ist, in einem Fall, in dem der Wechselrichter (12) abgeschaltet ist.

5. Verfahren zur Isolationsüberwachung nach Anspruch 1, weiter umfassend:
Bestimmen (S302), dass ein Isolationsfehler auftritt, wenn überwacht wird, dass ein Zeitraum, in dem der Wechselstrom-Isolationswiderstand kleiner als ein zweiter Fehlerschwellwert ist, eine zweite voreingestellte Zeitspanne erreicht, und Bestimmen, basierend auf einer vorbestimmten Fehlerortungslösung, ob der Isolationsfehler auf der Wechselstromseite oder der Gleichstromseite auftritt, in dem Zeitraum, in dem der Wechselrichter (12) mit dem Stromnetz verbunden ist.

6. Verfahren zur Isolationsüberwachung nach Anspruch 5, wobei das Bestimmen basierend auf einer vorbestimmten Fehlerortungslösung, ob der Isolationsfehler auf der Wechselstromseite oder der Gleichstromseite auftritt, umfasst:
Steuern des Wechselrichters (12), um abgeschaltet zu werden und die Gleichstrom-Isolationsüberwachung auszulösen, und Bestimmen, dass der Isolationsfehler auf der Gleichstromseite auftritt, in einem Fall, in dem der Isolationswiderstand eines Pluspols eines Photovoltaikstrangs gegenüber Erde oder der Isolationswiderstand eines Minuspols des Photovoltaikstrangs gegenüber Erde kleiner als ein Schutzschwellenwert ist; und
Auslösen der Wechselstrom-Isolationsüberwachung und Bestimmen, dass der Isolationsfehler auf der Wechselstromseite auftritt, wenn überwacht wird, dass der Wechselstrom-Isolationswiderstand kleiner als ein dritter Fehlerschwellenwert ist.

7. Verfahren zur Isolationsüberwachung nach Anspruch 6, weiter umfassend:
Ausgeben einer zweiten Wechselstrom-Isolationsfehler-Warnmeldung und Trennen eines Niederspannungssystems, in dem sich der Wechselrichter (12) befindet, vom Stromnetz, wenn bestimmt wird, dass der Isolationsfehler auf der Wechselstromseite auftritt.

8. Verfahren zur Isolationsüberwachung nach Anspruch 7, weiter umfassend:
Steuern des Wechselrichters (12), um den Betrieb zu beenden und kontinuierlich eine Isolationsüberwachung durchzuführen, als Reaktion auf einen Fehler beim Trennen des Niederspannungssystems vom Stromnetz; und
Beenden des Ausgebens der zweiten Wechselstrom-Isolationsfehler-Warnmeldung und Steuern des Wechselrichters (12), um den Betrieb wieder aufzunehmen, um mit dem Stromnetz verbunden zu werden, wenn der Isolationsfehler erfolgreich behoben wurde.

9. Verfahren zur Isolationsüberwachung nach Anspruch 5, weiter umfassend:
Bestimmen (S203), dass der Wechselstrom-Isolationswiderstand abnormal ist, und Ausgeben einer zweiten Alarmmeldung, die angibt, dass der Wechselstrom-Isolationswiderstand abnormal ist, wenn überwacht wird, dass ein Zeitraum, in dem der Wechselstrom-Isolationswiderstand größer als der zweite Fehlerschwellenwert und kleiner als ein zweiter Alarmschwellenwert ist, eine dritte voreingestellte Zeitspanne erreicht, in dem Zeitraum, in dem der Wechselrichter (12) mit dem Stromnetz verbunden ist.

10. Verfahren zur Isolationsüberwachung nach Anspruch 9, weiter umfassend:
Bestimmen (S204), dass der Wechselstrom-Isolationswiderstand wieder zu normal zurückkehrt, Beenden des Ausgebens der zweiten Alarmmeldung und Beenden des Durchführens der Wechselstrom-Isolationsüberwachung, sobald überwacht wird, dass der Wechselstrom-Isolationswiderstand größer als der zweite Alarmschwellenwert ist, in dem Zeitraum, in dem der Wechselrichter (12) mit dem Stromnetz verbunden ist.

11. Verfahren zur Isolationsüberwachung nach Anspruch 1, weiter umfassend:
in dem Zeitraum, in dem der Wechselrichter (12) mit dem Stromnetz verbunden ist, ein Zurücksetzen eines Zeitgebers zur Isolationsüberwachung und ein kontinuierliches Durchführen der Wechselstrom-Isolationsüberwachung, wenn überwacht wird, dass eine Alarmanzeige, die einen niedrigen Isolationswiderstand angibt, gültig ist; und Bestimmen, dass der Wechselstrom-Isolationswiderstand wieder zu normal zurückkehrt, Ändern der Alarmanzeige, die einen niedrigen Isolationswiderstand angibt, zu ungültig und Beenden des Durchführens der Wechselstrom-Isolationsüberwachung, wenn überwacht wird, dass ein Zeitraum, in dem der Wechselstrom-Isolationswiderstand größer als ein zweiter Wiederherstellungsschwellenwert ist, eine voreingestellte Wechselstrom-Isolationsalarm-Wiederherstellungszeitspanne erreicht.

12. Verfahren zur Isolationsüberwachung nach Anspruch 1, weiter umfassend:
Umschalten, wenn der Wechselrichter (12) stoppt oder ein anderer Fehler als ein Isolationsfehler im Wechselrichter (12) in dem Zeitraum auftritt, in dem der Wechselrichter (12) mit dem Netz verbunden ist, der Isolationsüberwachung von einem Modus, in dem der Wechselrichter (12) mit dem Stromnetz verbunden ist, in einen Modus, in dem der Wechselrichter (12) abgeschaltet ist, in dem Zeitraum, in dem der Wechselrichter (12) mit dem Netz verbunden ist.

13. Verfahren zur Isolationsüberwachung nach Anspruch 1, wobei das Steuern der Wechselstrom-Isolationsüberwachungsvorrichtung (14), um kontinuierlich eine Wechselstrom-Isolationsüberwachung auf der Wechselstromseite des Wechselrichters (12) durchzuführen, wenn überwacht wird, dass der Wechselrichter (12) abgeschaltet ist, umfasst:
Steuern der Wechselstrom-Isolationsüberwachungsvorrichtung (14), um kontinuierlich die Wechselstrom-Isolationsüberwachung auf der Wechselstromseite durchzuführen, und Steuern der Anti-PID-Vorrichtung (13), um den Betrieb zu beenden, wenn überwacht wird, dass der Wechselrichter (12) abgeschaltet ist, in einem Fall, in dem die Anti-PID-Vorrichtung (13) auf der Wechselstromseite angeordnet ist; oder
Steuern der Wechselstrom-Isolationsüberwachungsvorrichtung (14), um kontinuierlich die Wechselstrom-Isolationsüberwachung auf der Wechselstromseite durchzuführen, und Steuern der Anti-PID-Vorrichtung (13), um auf der Gleichstromseite in Betrieb zu sein, wenn überwacht wird, dass der Wechselrichter (12) abgeschaltet ist, in einem Fall, in dem die Anti-PID-Vorrichtung (13) auf der Gleichstromseite angeordnet ist.

14. Einrichtung zur Isolationsüberwachung, umfassend:
eine Wechselstrom-Isolationsüberwachungseinheit (401), die dazu konfiguriert ist, eine Wechselstrom-Isolationsüberwachungsvorrichtung (14) zu steuern, um kontinuierlich eine Wechselstrom-Isolationsüberwachung auf einer Wechselstromseite eines Wechselrichters (12) durchzuführen;
eine Gleichstrom-Isolationsüberwachungseinheit (402), die dazu konfiguriert ist, eine Gleichstrom-Isolationsüberwachung auf einer Gleichstromseite des Wechselrichters (12) durchzuführen
**dadurch gekennzeichnet, dass**
die Wechselstrom-Isolationsüberwachungseinheit (401) dazu konfiguriert ist, die Wechselstrom-Isolationsüberwachungsvorrichtung (14) zu steuern, um kontinuierlich die Wechselstrom-Überwachung auf einer Wechselstromseite eines Wechselrichters (12) durchzuführen, wenn überwacht wird, dass der Wechselrichter (12) abgeschaltet ist;
die Gleichstromüberwachungseinheit (402) dazu konfiguriert ist, die Gleichstrom-Isolationsüberwachung auf der Gleichstromseite des Wechselrichters (12) durchzuführen, bevor der Wechselrichter (12) mit einem Stromnetz verbunden wird, wenn überwacht wird, dass der Wechselstrom-Isolationswiderstand eine voreingestellte normale Wechselstrom-Widerstandsbedingung erfüllt und dass der Wechselrichter (12) in Betrieb ist und eine Netzverbindungsbedingung erfüllt; und
eine Steuereinheit (403), die dazu konfiguriert ist, den Wechselrichter (12), der mit dem Stromnetz verbunden werden soll, zu steuern, und die Wechselstrom-Isolationsüberwachung und die Gleichstrom-Isolationsüberwachung zu beenden, wenn überwacht wird, dass der Gleichstrom-Isolationswiderstand eine voreingestellte normale Gleichstrom-Widerstandsbedingung erfüllt, und eine Anti-Potential-induzierte-Degradations-, Anti-PID-, Vorrichtung (13) und eine Wechselstrom-Isolationsüberwachungsvorrichtung (14) zu steuern, um abwechselnd in einem Zeitraum in Betrieb zu sein, in dem der Wechselrichter (12) mit dem Stromnetz verbunden ist.

15. System zum Erzeugen von Elektrizität aus erneuerbarer Energie, umfassend:
eine Anti-Potential-induzierte-Degradations-, Anti-PID-, Vorrichtung (13);
eine Wechselstrom-Isolationsüberwachungsvorrichtung (14); und
eine Steuervorrichtung, umfassend einen Prozessor (1), einen Speicher (2) und ein in dem Speicher (2) gespeichertes und durch den Prozessor (1) ausführbares Computerprogramm, wobei der Prozessor (1) dazu konfiguriert ist, das Computerprogramm auszuführen, um das Verfahren zur Isolationsüberwachung nach einem der Ansprüche 1 bis 13 durchzuführen.

## Revendications

1. Procédé de surveillance d'isolation, comprenant les étapes consistant à :
commander (S101) un dispositif de surveillance d'isolation en courant alternatif (14) pour effectuer en permanence une surveillance d'isolation en courant alternatif du côté courant alternatif d'un onduleur (12) ;
effectuer (S102) une surveillance d'isolation en courant continu du côté courant continu de l'onduleur (12)
**caractérisé en ce que**
la surveillance d'isolation en courant alternatif du côté courant alternatif de l'onduleur (12) est effectuée en permanence lorsqu'il est détecté que l'onduleur (12) est arrêté ;
la surveillance d'isolation en courant continu du côté courant continu de l'onduleur (12) est effectuée avant que l'onduleur (12) ne soit connecté à un réseau électrique lorsqu'il est détecté que la résistance d'isolation en courant alternatif satisfait une condition de résistance du courant alternatif normale prédéfinie et que l'onduleur (12) fonctionne et satisfait une condition de connexion au réseau ; et
commander (S103) l'onduleur (12) pour qu'il soit connecté au réseau électrique et arrêter la surveillance d'isolation en courant alternatif et la surveillance d'isolation en courant continu lorsqu'il est détecté que la résistance d'isolation en courant continu satisfait une condition de résistance en courant continu normale prédéfinie, et commander un dispositif anti-dégradation induite par le potentiel, anti-PID (13) et le dispositif de surveillance d'isolation en courant alternatif (14) pour qu'ils fonctionnent en alternance pendant une période au cours de laquelle l'onduleur (12) est connecté au réseau électrique.

2. Procédé de surveillance d'isolation selon la revendication 1, comprenant en outre les étapes consistant à :
déterminer (S202) qu'un défaut d'isolation en courant alternatif se produit du côté courant alternatif, produire un premier message d'alerte de défaut d'isolation en courant alternatif et déconnecter du réseau électrique un système basse tension où se situe l'onduleur (12), lorsqu'il est détecté qu'une période pendant laquelle la résistance d'isolation en courant alternatif est inférieure à un premier seuil de défaut atteint une première période de temps prédéfinie, dans le cas où l'onduleur (12) est arrêté.

3. Procédé de surveillance d'isolation selon la revendication 2, comprenant en outre les étapes consistant à :
déterminer (S203) que la résistance d'isolation en courant alternatif est anormale et produire un premier message d'alarme indiquant que la résistance d'isolation en courant alternatif est anormale lorsqu'il est détecté qu'une période pendant laquelle la résistance d'isolation en courant alternatif est supérieure au premier seuil de défaut et inférieure à un premier seuil d'alarme atteint une deuxième période prédéfinie, dans le cas où l'onduleur (12) est arrêté.

4. Procédé de surveillance d'isolation selon la revendication 3, comprenant en outre les étapes consistant à :
déterminer (S204) que la résistance d'isolation en courant alternatif revient à la normale, arrêter la production du premier message d'alarme et arrêter la surveillance d'isolation en courant alternatif une fois qu'il est détecté que la résistance d'isolation en courant alternatif est supérieure à un premier seuil de rétablissement et inférieure au premier seuil d'alarme, dans le cas où l'onduleur (12) est arrêté.

5. Procédé de surveillance d'isolation selon la revendication 1, comprenant en outre l'étape consistant à :
déterminer (S302) qu'un défaut d'isolation se produit lorsqu'il est détecté qu'une période pendant laquelle la résistance d'isolation en courant alternatif est inférieure à un deuxième seuil de défaut atteint une deuxième période de temps prédéfinie et déterminer, sur la base d'une solution de localisation de défaut prédéterminée, si le défaut d'isolation se produit du côté courant alternatif ou du côté courant continu, pendant la période au cours de laquelle l'onduleur (12) est connecté au réseau électrique.

6. Procédé de surveillance d'isolation selon la revendication 5, dans lequel la détermination, sur la base d'une solution de localisation de défaut prédéterminée, de savoir si le défaut d'isolation se produit du côté courant alternatif ou du côté courant continu comprend les étapes consistant à :
commander l'arrêt de l'onduleur (12) et déclencher la surveillance d'isolation en courant continu, et déterminer que le défaut d'isolation se produit du côté du courant continu dans le cas où la résistance d'isolation d'un pôle positif d'une chaîne photovoltaïque par rapport à la terre ou la résistance d'isolation d'un pôle négatif de la chaîne photovoltaïque par rapport à la terre est inférieure à un seuil de protection ; et
déclencher la surveillance d'isolation du courant alternatif, et déterminer que le défaut d'isolation se produit du côté du courant alternatif lorsqu'il est détecté que la résistance d'isolation en courant alternatif est inférieure à un troisième seuil de défaut.

7. Procédé de surveillance d'isolation selon la revendication 6, comprenant en outre l'étape consistant à :
produire un deuxième message d'alerte de défaut d'isolation du courant alternatif et déconnecter du réseau électrique un système basse tension où se situe l'onduleur (12) lorsqu'il est déterminé que le défaut d'isolation se produit du côté du courant alternatif.

8. Procédé de surveillance d'isolation selon la revendication 7, comprenant en outre les étapes consistant à :
commander l'onduleur (12) pour qu'il cesse de fonctionner et effectuer en permanence une surveillance d'isolation en réponse à un échec de la déconnexion du système basse tension du réseau électrique ; et
cesser d'émettre le deuxième message d'alerte de défaut d'isolation en courant alternatif et commander l'onduleur (12) pour qu'il reprenne son fonctionnement de manière à être connecté au réseau électrique lorsque le défaut d'isolation est éliminé avec succès.

9. Procédé de surveillance d'isolation selon la revendication 5, comprenant en outre les étapes consistant à :
déterminer (S203) que la résistance d'isolation en courant alternatif est anormale et émettre un deuxième message d'alarme indiquant que la résistance d'isolation en courant alternatif est anormale lorsqu'il est détecté qu'une période pendant laquelle la résistance d'isolation en courant alternatif est supérieure au deuxième seuil de défaut et inférieure à un deuxième seuil d'alarme atteint une troisième période de temps prédéfinie, pendant la période pendant laquelle l'onduleur (12) est connecté au réseau électrique.

10. Procédé de surveillance d'isolation selon la revendication 9, comprenant en outre les étapes consistant à :
déterminer (S204) que la résistance d'isolation en courant alternatif revient à la normale, arrêter l'émission du deuxième message d'alarme et arrêter la surveillance d'isolation en courant alternatif une fois qu'il est détecté que la résistance d'isolation en courant alternatif est supérieure au deuxième seuil d'alarme, pendant la période pendant laquelle l'onduleur (12) est connecté au réseau électrique.

11. Procédé de surveillance d'isolation selon la revendication 1, comprenant en outre les étapes consistant à :
pendant la période pendant laquelle l'onduleur (12) est connecté au réseau électrique, la réinitialisation d'une minuterie pour la surveillance d'isolation et l'exécution constante de la surveillance d'isolation en courant alternatif de manière forcée lorsqu'il est détecté qu'un indicateur d'alarme indiquant une faible résistance d'isolation est valide ; et déterminer que la résistance d'isolation en courant alternatif revient à la normale, changer l'indicateur d'alarme indiquant une faible résistance d'isolation pour qu'il soit invalide et arrêter d'effectuer la surveillance d'isolation en courant alternatif lorsqu'il est détecté qu'une période pendant laquelle la résistance d'isolation en courant alternatif est supérieure à un deuxième seuil de rétablissement atteint une période de temps de rétablissement d'alarme d'isolation en courant alternatif prédéfinie.

12. Procédé de surveillance d'isolation selon la revendication 1, comprenant en outre l'étape consistant à :
commuter, lorsque l'onduleur (12) s'arrête ou qu'un défaut autre qu'un défaut d'isolation se produit dans l'onduleur (12) pendant la période pendant laquelle l'onduleur (12) est connecté au réseau, la surveillance d'isolation d'un mode dans lequel l'onduleur (12) est connecté au réseau électrique à un mode dans lequel l'onduleur (12) est arrêté, pendant la période pendant laquelle l'onduleur (12) est connecté au réseau.

13. Procédé de surveillance d'isolation selon la revendication 1, dans lequel la commande du dispositif de surveillance d'isolation en courant alternatif (14) pour effectuer en permanence une surveillance d'isolation en courant alternatif du côté courant alternatif de l'onduleur (12) lorsqu'il est détecté que l'onduleur (12) est arrêté comprend les étapes consistant à :
commander le dispositif de surveillance d'isolation en courant alternatif (14) pour effectuer en permanence la surveillance d'isolation en courant alternatif du côté courant alternatif et commander le dispositif anti-PID (13) pour arrêter son fonctionnement, lorsqu'il est détecté que l'onduleur (12) est arrêté dans le cas où le dispositif anti-PID (13) est disposé du côté courant alternatif ; ou
commander le dispositif de surveillance d'isolation en courant alternatif (14) pour effectuer en permanence la surveillance d'isolation en courant alternatif du côté courant alternatif et commander le dispositif anti-PID (13) pour qu'il fonctionne du côté courant continu, lorsqu'il est détecté que l'onduleur (12) est arrêté dans un cas où le dispositif anti-PID (13) est disposé du côté courant continu.

14. Appareil de surveillance d'isolation, comprenant :
une unité de surveillance d'isolation en courant alternatif (401) configurée pour commander un dispositif de surveillance d'isolation en courant alternatif (14) afin d'effectuer en permanence une surveillance d'isolation en courant alternatif du côté courant alternatif d'un onduleur (12) ;
une unité de surveillance d'isolation en courant continu (402) configurée pour effectuer une surveillance d'isolation en courant continu du côté courant continu de l'onduleur (12)
**caractérisé en ce que**
l'unité de surveillance d'isolation en courant alternatif (401) est configurée pour commander le dispositif de surveillance d'isolation en courant alternatif (14) afin d'effectuer en permanence la surveillance en courant alternatif du côté courant alternatif de l'onduleur (12) lorsqu'il est détecté que l'onduleur (12) est arrêté ;
l'unité de surveillance en courant continu (402) est configurée pour effectuer la surveillance d'isolation en courant continu du côté courant continu de l'onduleur (12) avant que l'onduleur (12) ne soit connecté à un réseau électrique lorsqu'il est détecté que la résistance d'isolation en courant alternatif répond à une condition de résistance en courant alternatif normale prédéfinie et que l'onduleur (12) fonctionne et répond à une condition de connexion au réseau ; et
une unité de commande (403) configurée pour commander l'onduleur (12) afin qu'il soit connecté au réseau électrique et arrêter la surveillance d'isolation en courant alternatif et la surveillance d'isolation en courant continu lorsqu'il est détecté que la résistance d'isolation en courant continu répond à une condition de résistance en courant continu normale prédéfinie, et commander un dispositif anti-dégradation induite par le potentiel, anti-PID (13) et le dispositif de surveillance d'isolation en courant alternatif (14) pour qu'ils fonctionnent alternativement pendant une période au cours de laquelle l'onduleur (12) est connecté au réseau électrique.

15. Système pour produire de l'électricité à partir d'une énergie renouvelable, comprenant :
un dispositif anti-dégradation induite par le potentiel, anti-PID (13) ;
un dispositif de surveillance d'isolation en courant alternatif (14) ; et
un dispositif de commande comprenant un processeur (1), une mémoire (2) et un programme informatique stocké dans la mémoire (2) et exécutable par le processeur (1), dans lequel le processeur (1) est configuré pour exécuter le programme informatique afin de mettre en œuvre le procédé de surveillance d'isolation selon l'une quelconque des revendications 1 à 13.
